# FASCICULE DE BREVET EUROPEEN

(11) **EP 4 466 730 B1**
(45) Date de publication et mention de la délivrance du brevet: **01.04.2026**
(21) Numéro de dépôt: 23703100.0
(22) Date de dépôt: 17.01.2023
(51) Int. Cl.: H01L 21/02, H01L 21/78

(54) **PROCEDE DE FABRICATION D'UNE STRUCTURE COMPRENANT AU MOINS DEUX PAVES SUR UN SUBSTRAT**
VERFAHREN ZUR HERSTELLUNG EINER STRUKTUR MIT MINDESTENS ZWEI FLIESEN AUF EINEM SUBSTRAT
METHOD FOR PRODUCING A STRUCTURE COMPRISING AT LEAST TWO TILES ON A SUBSTRATE

(30) Priorité: 17.01.2022 FR 2200361
(43) Date de publication de la demande: 27.11.2024
(73) Titulaire: SOITEC, 38190 Bernin (FR)
(72) Inventeur: GHYSELEN, Bruno, 38190 BERNIN (FR)
(74) Mandataire: Regimbeau
(86) Numéro de dépôt international: PCT/FR2023/050061
(87) Numéro de publication internationale: WO 2023/135401

(56) Documents cités:
- FR-A1- 3 094 559
- US-A1- 2010 267 216
- US-A1- 2020 244 046
- US-A1- 2020 366 050

## Description

### DOMAINE TECHNIQUE

L'invention concerne un procédé de fabrication d'une structure comprenant au moins deux pavés sur un substrat support.

### ETAT DE LA TECHNIQUE

Dans le domaine de la microélectronique, de l'optique ou de l'optoélectronique, la conception de structures multicouches nécessite parfois de transférer des pavés se présentant sous forme de portions d'une couche d'un substrat donneur sur un substrat support ou substrat receveur. Le document US2020/366050 divulgue un procédé de fabrication d'une structure comprenant au moins deux pavés sur un substrat, comprenant : - le placement, sur un substrat support, d'au moins deux pavés pour constituer un affichage à LEDs, lesdits pavés étant agencés sur ledit substrat support. Le document US2010/267216 décrit un procédé de fabrication d'une structure comprenant un pavage et comprenant : - le placement, sur un substrat support d'au moins deux pavés , lesdits pavés étant agencés sur ledit substrat support selon une distribution et/ou une géométrie, qui est considérée comme erronée de par l'imprécision inhérente au transfert, et - la gravure d'au moins un pavé de sorte à corriger les bords des dits pavés qui manqueraient d'adhésion.

Ce type de procédé est généralement appelé procédé de pavage, et met en jeu un transfert partiel d'une couche prélevée dans le substrat donneur pour former un ou plusieurs pavés agencés selon un motif ou à un emplacement prédéterminé sur le substrat support.

Un tel pavage peut être rendu nécessaire par une différence de taille entre le substrat donneur et le substrat support. En effet, du fait de cette différence de taille, il n'est pas possible de transférer une couche entière du substrat donneur sur le substrat support.

Un procédé de transfert de couche bien connu est le procédé Smart Cut^{™}, dans lequel on forme par implantation d'espèces atomiques dans le substrat donneur une zone de fragilisation délimitant la couche à transférer, on colle le substrat donneur sur le substrat support et on détache le substrat donneur le long de la zone de fragilisation pour transférer la couche du substrat donneur sur le substrat support. Cependant, ce procédé suppose que le substrat donneur et le substrat support présentent une taille identique.

Or, si des substrats de silicium sont disponibles avec une taille relativement grande, typiquement un diamètre de 300 mm, d'autres matériaux d'intérêt n'existent actuellement que sous la forme de substrats massifs de plus petite taille, par exemple de 10 ou 15 cm de diamètre. Par ailleurs, ces matériaux d'intérêt sont parfois particulièrement onéreux, de sorte qu'il est souhaitable de minimiser les éventuels déchets formés lors du transfert. Tel est le cas en particulier des matériaux semi-conducteurs III-V, comprenant les nitrures (par exemple pour ce qui est des composés binaires, le nitrure d'indium (InN), le nitrure de gallium (GaN) et le nitrure d'aluminium (AIN)), les arséniures (par exemple pour ce qui est des composés binaires, l'arséniure d'indium (InAs), l'arséniure de gallium (GaAs) et l'arséniure d'aluminium (AlAs)), et les phosphures (par exemple pour ce qui est des composés binaires, le phosphure d'indium (InP), le phosphure de gallium (GaP) et le phosphure d'aluminium (AIP)).

Au lieu de transférer une couche entière du substrat donneur, une solution basée sur le procédé Smart Cut^{™} consiste à prélever d'au moins un substrat donneur un ou plusieurs pavés et de reporter lesdits pavés sur un premier substrat, pour former un substrat dit pseudo-donneur, former par implantation d'espèces atomiques une zone de fragilisation dans chaque pavé, coller le substrat pseudo-donneur sur un second substrat par l'intermédiaire des pavés, et détacher chaque pavé le long de la zone de fragilisation de sorte à transférer une portion de chaque pavé sur le second substrat. Les premier et second substrats présentent une taille identique.

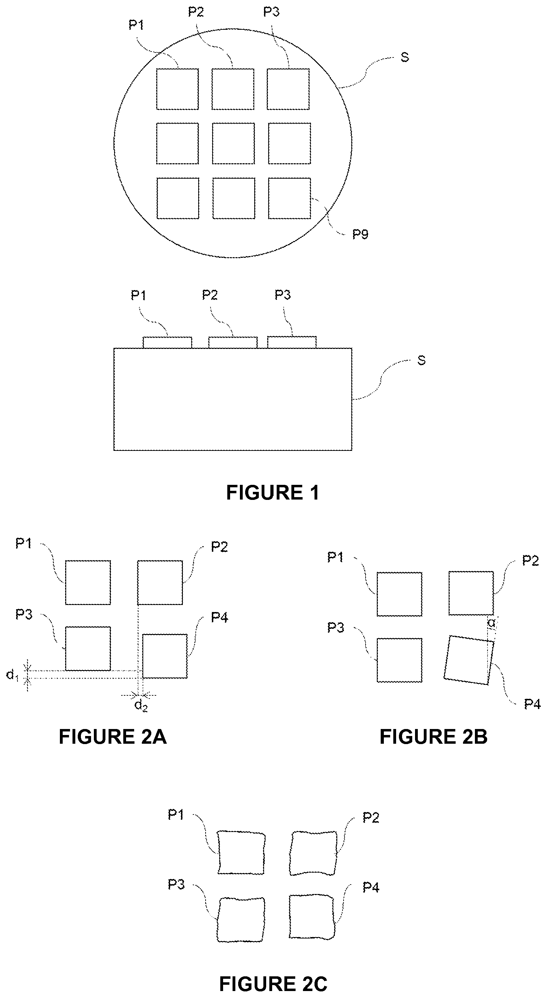

La figure 1 représente une vue de dessus et une vue en coupe d'un substrat support S sur lequel ont été disposés une pluralité de pavés P1-P9 d'au moins un substrat donneur. Dans cet exemple, les pavés sont au nombre de neuf et sont répartis selon trois lignes et trois colonnes.

La fabrication de ladite structure peut être réalisée par la technique dite « Pick and Place » en anglais, dans laquelle ledit au moins un substrat donneur est découpé en pavés puis chaque pavé est placé sur la surface du substrat support à l'aide d'un robot.

Cependant, dans la mesure où chaque pavé est reporté individuellement sur le premier substrat, cette technique peut être très lente, d'autant plus que la précision recherchée d'alignement des pavés est exigeante. La précision du robot peut par ailleurs être inférieure à la précision requise pour le placement et l'orientation des pavés. On observe par conséquent des défauts de positionnement des pavés par rapport à un référentiel du substrat support, et/ou des défauts d'alignement des pavés entre eux.

Des exemples de tels défauts sont illustrés sur les figures 2A et 2B, qui représentent quatre pavés P1-P4 agencés selon deux lignes (orientées selon la direction horizontale sur ces figures) et deux colonnes (orientées selon la direction verticale sur ces figures). Sur la figure 2A, on observe que le pavé P4 est décalé d'une distance d₁ dans la direction verticale par rapport au pavé P3 qui appartient à la colonne adjacente, et d'une distance d₂ dans la direction horizontale par rapport au pavé P2 qui appartient à la même colonne. Sur la figure 2B, on observe que le pavé P4 est incliné d'un angle α par rapport à la direction verticale, de sorte que ses bords ne sont pas parallèles à ceux des pavés adjacents.

Or, ces défauts d'alignement ou de positionnement sont problématiques pour la fabrication ultérieure de composants électroniques dans ou sur les pavés, qui doit respecter un plan particulièrement précis.

Par ailleurs, comme illustré sur la figure 2C, lors de l'opération de transfert de couche ou lorsque plusieurs transferts sont réalisés successivement à partir du substrat pseudo-donneur, on peut observer un phénomène d'effet de bord qui dégrade la forme des bords des pavés P1-P4 et est donc susceptible d'affecter la fabrication ultérieure de composants dans ou sur les pavés, notamment au voisinage des bords.

### BREVE DESCRIPTION DE L'INVENTION

Un but de l'invention est de concevoir un procédé de fabrication d'une structure comprenant au moins deux pavés sur un substrat support, qui permette de réduire les défauts de positionnement et d'alignement des pavés.

A cet effet, l'invention propose un Procédé de fabrication d'une structure comprenant au moins deux pavés sur un substrat, comprenant :
- le placement, sur un substrat support, d'au moins deux pavés, lesdits pavés étant agencés sur ledit substrat support selon une distribution et/ou une géométrie erronée par rapport à une distribution et/ou une géométrie cible ;
- la formation d'un masque comprenant un film protecteur recouvrant en partie lesdits pavés selon un motif définissant la distribution et/ou la géométrie cible et au moins une ouverture s'étendant autour du film protecteur ;
- la gravure d'au moins un pavé au travers de l'ouverture du masque de sorte à corriger l'agencement des pavés selon la distribution et/ou la géométrie cible.

Par « gravure » on entend dans le présent texte une attaque chimique et/ou physique du matériau des pavés, conduisant à une élimination de la zone des pavés non recouverte par le film protecteur.

Le masque est positionné par une technique très précise par rapport à un référentiel de l'ensemble des pavés, ou par rapport à un référentiel du substrat support sur lequel s'étendent les pavés, de sorte que les pavés qui sont obtenus à l'issue de la gravure sont positionnés et/ou façonnés précisément.

Par « référentiel » on entend dans le présent texte un système de coordonnées attaché à un substrat portant les pavés, ou à l'ensemble des pavés, et qui permet de définir la position de chaque point de la surface du substrat ou de l'ensemble des pavés.

Par exemple, ledit référentiel peut comprendre un point d'origine repérable sur un bord du substrat, tel qu'une encoche classiquement utilisée dans l'industrie des semi-conducteurs, et deux axes orthogonaux s'étendant dans le plan du substrat, l'un des axes s'étendant diamétralement à partir de l'encoche et l'autre axe coupant le premier axe au centre du substrat. Un tel référentiel est utilisé pour définir la position des composants à former dans ou sur le substrat et pour localiser les différentes étapes de procédé à mettre en oeuvre pour former lesdits composants.

De manière alternative, le référentiel peut ne pas être défini par rapport au substrat support mais par rapport à l'ensemble des pavés. Par exemple, ledit référentiel peut être défini par une ou plusieurs marques formées sur l'un au moins des pavés et/ou sur le substrat support.

Dans certains modes de réalisation, les pavés sont placés successivement sur le substrat support.

Dans d'autres modes de réalisation, les pavés sont placés simultanément sur le substrat support.

En particulier, le procédé peut comprendre :
- la formation d'un substrat pseudo-donneur par placement de chaque pavé d'au moins un substrat donneur sur un premier substrat support ;
- le collage dudit substrat pseudo-donneur sur un second substrat support par l'intermédiaire des pavés ;
- le transfert d'une portion desdits pavés sur le second substrat support.

Dans certains modes de réalisation, le premier et le second substrat support présentent un diamètre identique, supérieur au diamètre du substrat donneur.

De manière particulièrement avantageuse, le collage du substrat pseudo-donneur sur le second substrat support peut être réalisé par adhésion moléculaire.

Le transfert de chaque portion de pavé peut comprendre successivement la formation d'une zone de fragilisation par implantation d'espèces atomiques dans chaque pavé placé sur le substrat pseudo-donneur pour définir une portion à transférer, le collage du substrat pseudo-donneur sur le second substrat support par l'intermédiaire des pavés, et le détachement de chaque pavé le long de la zone de fragilisation.

Chaque pavé peut typiquement présenter une épaisseur comprise entre 20 µm et 1000 µm, de préférence comprise entre 100 µm et 700 µm, et la portion transférée de chaque pavé présente une épaisseur comprise entre 30 nm et 1,5 µm.

La formation du masque et la gravure peuvent être mises en oeuvre après le transfert de chaque portion de pavé sur le second substrat support. De manière alternative ou additionnelle, la formation du masque et la gravure peuvent être mises en oeuvre sur les pavés du substrat pseudo-donneur avant le collage sur le second substrat support.

Dans certaines formes d'exécution, chaque pavé présente un côté de longueur inférieure ou égale à 10 mm, de préférence inférieure ou égale à 5 mm, et de manière encore préférée inférieure ou égale à 2 mm.

Dans d'autres formes d'exécution, chaque pavé présente un côté de longueur supérieure ou égale à 3 mm, de préférence supérieure ou égale à 5 mm, et de manière préférée supérieure ou égale à 8 mm.

Le film protecteur peut avantageusement recouvrir chaque pavé selon au moins deux motifs séparés par des ouvertures et la gravure dudit pavé au travers desdites ouvertures du masque forme alors au moins deux portions de pavés selon les motifs à partir dudit pavé.

De manière particulièrement avantageuse, chaque pavé peut comprendre :
- un matériau semi-conducteur, tel qu'un matériau III-V, notamment le nitrure d'indium (InN), le nitrure de gallium (GaN), le nitrure d'aluminium (AIN), l'arséniure d'indium (InAs), l'arséniure de gallium (GaAs), l'arséniure d'aluminium (AlAs), le phosphure d'indium (InP), le phosphure de gallium (GaP) ou le phosphure d'aluminium (AIP), ou un matériau IV ou IV-IV, notamment le germanium ou le carbure de silicium (SiC),
- un matériau piézoélectrique, tel que le tantalate de lithium (LiTaO₃), le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AIScN), et/ou
- un matériau électriquement isolant, tel que le diamant, le titanate de strontium, la zircone yttriée ou le saphir.

Dans certains modes de réalisation, le procédé comprend la formation d'au moins une couche épitaxiale sur chaque pavé, la formation du masque et la gravure étant mises en oeuvre après ladite étape d'épitaxie.

### BREVE DESCRIPTION DES FIGURES

D'autres caractéristiques et avantages de l'invention ressortiront de la description détaillée qui va suivre, en référence aux dessins annexés, sur lesquels :
- la figure 1 représente une vue de dessus et une vue en coupe d'un substrat support sur lequel ont été placés une pluralité de pavés d'un substrat donneur ;
- les figures 2A à 2C représentent, en vue de dessus, trois exemples de défauts d'alignement ou de géométrie des pavés sur un substrat support du type illustré sur la figure 1 ;
- la figure 3 illustre un mode de réalisation particulier d'un substrat pseudo-donneur ;
- les figures 4A à 4E illustrent respectivement des étapes de prélèvement de pavés d'un substrat donneur, de placement desdits pavés sur un premier substrat support pour former un substrat pseudo-donneur, de formation d'une zone de fragilisation dans lesdits pavés, de collage du substrat pseudo-donneur sur un second substrat support par l'intermédiaire des pavés et de transfert des portions des pavés sur le second substrat support suite au détachement des pavés le long de la zone de fragilisation ;
- la figure 5 représente une vue de dessus et une vue en coupe d'un substrat support recouvert des pavés ;
- la figure 6 représente une vue de dessus et une vue en coupe de la structure de la figure 5 après formation d'un masque sur les pavés par photolithographie, selon une première forme d'exécution de l'invention ;
- la figure 7 représente une vue de dessus et une vue en coupe de la structure de la figure 6 après gravure des régions des pavés non recouvertes par le masque ;
- la figure 8 représente une vue de dessus et une vue en coupe de la structure de la figure 7 après retrait du masque ;
- les figures 9A à 9C illustrent de manière schématique comment les défauts d'alignement ou de géométrie représentés sur les figures 2A à 2C ont été corrigés grâce à l'invention ;
- la figure 10 représente une vue de dessus et une vue en coupe d'un substrat support recouvert de pavés de plus grande dimension que dans le mode de réalisation de la figure 5 ;
- la figure 11 représente une vue de dessus et une vue en coupe de la structure de la figure 10 après formation d'un masque sur les pavés par photolithographie, selon une seconde forme d'exécution de l'invention ;
- la figure 12 représente une vue de dessus et une vue en coupe de la structure de la figure 11 après gravure des régions des pavés non recouvertes par le masque ;
- la figure 13 représente une vue de dessus et une vue en coupe de la structure de la figure 12 après retrait du masque ;
- les figures 14A à 14D illustrent une troisième forme d'exécution de l'invention, dans laquelle, après le placement des pavés sur un substrat support, on fait croître une couche épitaxiale sur chaque pavé puis on applique le masque tel que défini plus haut sur la couche épitaxiale, et on grave à la fois la couche épitaxiale et les pavés pour corriger la géométrie et/ou la distribution des pavés.

Pour des raisons de lisibilité, les dessins ne sont pas nécessairement réalisés à l'échelle. Par ailleurs, le nombre de pavés schématisés sur les dessins n'est donné qu'à titre d'illustration.

### DESCRIPTION DETAILLEE DE MODES DE REALISATION

L'invention propose de corriger des défauts de distribution et/ou de géométrie de pavés placés sur un substrat support, pour obtenir une distribution et/ou une géométrie cible.

Ladite distribution et/ou géométrie cible peut être spécifiée, par exemple, par un fabricant de dispositifs pour la microélectronique, l'optique ou l'optoélectronique. En effet, la fabrication de tels dispositifs dans ou sur chaque pavé fait intervenir des techniques localisées qui nécessitent un emplacement et une forme précis pour chaque pavé.

A cet effet, après qu'au moins deux pavés ont été placés sur le substrat support, on forme un masque comprenant un film protecteur recouvrant en partie les pavés. Ledit masque comprend également au moins une ouverture autour du film. Chaque ouverture forme un accès pour un agent de gravure dont la composition est choisie pour attaquer chimiquement et/ou physiquement le matériau du pavé. Le film protecteur est en un matériau résistant à l'agent de gravure et qui protège donc le matériau du pavé de l'agent de gravure dans les zones couvertes par le film protecteur. Ainsi, l'application de l'agent de gravure ne grave le matériau du pavé que dans les zones non recouvertes par le film protecteur, ce qui permet de modifier la géométrie des pavés. Cette correction de la géométrie à l'échelle de chaque pavé permet également de corriger la distribution ou l'alignement des pavés les uns par rapport aux autres.

De manière particulièrement avantageuse, le masque est formé par photolithographie, le film protecteur étant alors formé d'une résine photosensible résistant à l'agent de gravure qui est une composition de gravure chimique. La photolithographie étant généralement plus précise que les procédés de placement des pavés, elle permet donc de garantir que les zones des pavés protégées par le film protecteur obéissent à la distribution et/ou à la géométrie cible.

De manière alternative, l'agent de gravure est un faisceau d'ions (technique connue sous le terme anglo-saxon de « sputtering ») et le masque comprend un fim protecteur métallique qui protège le matériau des pavés du faisceau d'ions dans les zones recouvertes par le film protecteur.

Le masque est retiré après que les pavés ont été gravés sur tout ou partie de leur épaisseur.

On notera qu'il est possible de s'affranchir de l'utilisation d'un masque si l'on utilise un procédé de gravure sélective mettant en œuvre un faisceau focalisé d'ions de gravure contrôlé pour balayer uniquement les zones des pavés à éliminer.

Ce procédé peut être mis en œuvre à différentes étapes d'un procédé de pavage.

Ainsi, le procédé peut être mis en œuvre après que des pavés ont été placés sur un premier substrat support depuis un ou plusieurs substrats donneurs.

Le premier substrat support peut être un support final ou un support temporaire.

Par ailleurs, le placement des pavés peut être réalisé successivement pavé par pavé ou simultanément pour l'ensemble des pavés.

Ainsi, par exemple, le premier substrat support recouvert des pavés peut être un substrat pseudo-donneur, destiné à transférer ultérieurement les pavés sur un second substrat support, qui peut être un support final ou un nouveau support temporaire.

Dans ce cas, le placement des pavés sur le premier substrat support peut être réalisé pavé par pavé, par exemple par le procédé de « Pick and Place » ; en revanche, le transfert des pavés du substrat pseudo-donneur sur le second substrat support peut être réalisé simultanément.

Le procédé de correction de la distribution et/ou de la géométrie des pavés peut être mis en œuvre après le placement des pavés sur le premier substrat support et/ou après le transfert des pavés sur le second substrat support. De manière préférée, le procédé est mis en œuvre après le transfert des pavés sur le second substrat support, afin de corriger les éventuels effets de bord liés à l'étape de transfert de couche.

Dans certains modes de réalisation, le nombre de pavés reste identique avant et après la mise en œuvre du procédé. Tel est le cas notamment lorsque les pavés sont de relativement petites dimensions, la gravure étant principalement mise en œuvre en périphérie de chaque pavé. Par exemple, chaque pavé présente initialement un côté de longueur inférieure ou égale à 10 mm, de préférence inférieure ou égale à 5 mm, et de manière encore préférée inférieure ou égale à 2 mm.

Dans d'autres modes de réalisation, le procédé permet de subdiviser un pavé en plusieurs pavés plus petits. Le procédé présente ainsi l'avantage de former des pavés de très petites dimensions sans avoir à les placer individuellement sur le substrat support, la gravure desdits pavés à partir de pavés plus grands étant plus rapide que le placement de chacun des petits pavés. Par exemple, chaque pavé présente initialement un côté de longueur supérieure ou égale à 3 mm, de préférence supérieure ou égale à 5 mm, et de manière préférée supérieure ou égale à 8 mm.

De manière avantageuse, les pavés sont en un matériau qui n'est pas disponible commercialement sous forme de substrat donneur de grandes dimensions. Ainsi, le substrat donneur peut présenter un diamètre inférieur à 30 cm, par exemple de l'ordre de 10 ou 15 cm.

Tel est le cas en particulier des matériaux semi-conducteurs III-V, comprenant les nitrures (par exemple pour ce qui est des composés binaires, le nitrure d'indium (InN), le nitrure de gallium (GaN) et le nitrure d'aluminium (AIN)), les arséniures (par exemple pour ce qui est des composés binaires, l'arséniure d'indium (InAs), l'arséniure de gallium (GaAs) et l'arséniure d'aluminium (AlAs)), et les phosphures (par exemple pour ce qui est des composés binaires, le phosphure d'indium (InP), le phosphure de gallium (GaP) et le phosphure d'aluminium (AIP)).

Ceci est le cas aussi pour des composés semi-conducteurs IV ou IV-IV, comme par exemple le germanium et le carbure de silicium.

Les pavés peuvent également être en un matériau piézoélectrique, par exemple le tantalate de lithium (LiTaO₃) ou encore le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AlScN) (liste non limitative).

Les pavés peuvent également être en un matériau électriquement isolant, tel que par exemple le diamant, le titanate de strontium (SrTiO₃), la zircone yttriée (YSZ), ou encore le saphir.

Compte tenu de la différence de taille entre le substrat donneur et le substrat support, plusieurs substrats donneurs peuvent être nécessaires pour paver l'ensemble de la surface du substrat support selon la densité de pavage souhaitée.

On notera que les pavés ne sont pas nécessairement en relief sur le substrat support. Par exemple, les pavés peuvent être placés dans des cavités formées dans la surface principale du substrat support, la surface supérieure des pavés affleurant à la surface du substrat support ou étant située au-dessus ou en-dessous de cette surface.

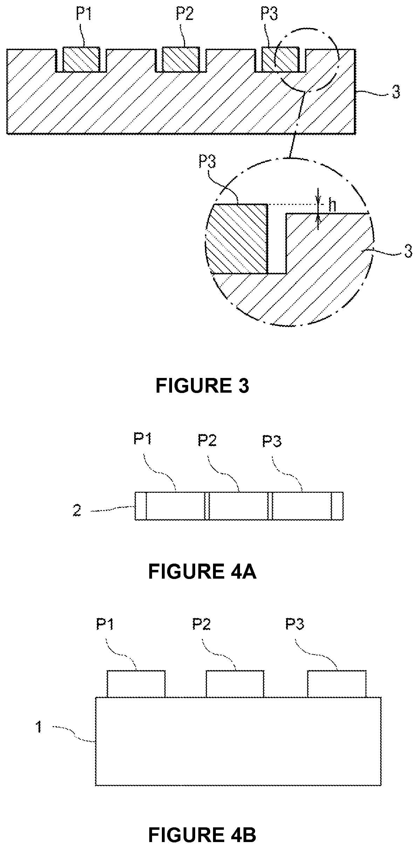

La figure 3 est une vue schématique en coupe d'un substrat pseudo-donneur selon un mode de réalisation particulier. Ledit substrat comprend des pavés P1, P2, P3 et un premier substrat support 2. Chaque pavé est agencé dans une cavité respective du substrat 2 formée dans la surface principale dudit substrat 2, de sorte que la surface libre des pavés est sensiblement alignée (coplanaire) avec la surface du substrat 2.

Comme on le voit mieux dans l'insert qui représente une vue grossie du pavé P3 dans sa cavité, la surface libre de chaque pavé est située à une hauteur h par rapport à la surface du substrat 2. La hauteur h peut être nulle (la surface libre des pavés et la surface principale du substrat étant coplanaires), positive (les pavés étant alors en léger relief par rapport à la surface principale du substrat) ou négative (les pavés étant alors en léger retrait par rapport à la surface principale du substrat). En valeur absolue, la hauteur h est typiquement comprise entre 1 et 10% de l'épaisseur totale de la portion transférée des pavés. Par ailleurs, la hauteur h peut être préférentiellement comprise entre quelques dixièmes de µm et quelques dizaines de µm.

Avantageusement, le mode de réalisation en relief, autrement dit, lorsque la hauteur h est positive, est le mode de réalisation préféré lorsque le pseudo-donneur est configuré pour être collé sur un substrat support 3 plan. Par ailleurs, un pseudo-donneur avec des pavés en retrait (la hauteur h est négative), peut être collé sur un substrat support 3 muni d'une surface embarquant une topologie configurée pour compenser la topologie du substrat pseudo-donneur de sorte que les pavés en retrait soient en contact avec la surface du substrat support 3.

Les figures 4A à 4E illustrent de manière schématique la formation d'un substrat pseudo-donneur comprenant les pavés placés sur un premier substrat support et le transfert des pavés sur un second substrat support.

En référence à la figure 4A, on découpe des pavés P1-P3 d'un substrat donneur 2. La découpe des pavés peut être réalisée par toute technique connue de l'homme de l'art. Elle peut notamment être réalisée par sciage et/ou clivage, ou encore par découpe laser. Elle peut aussi par exemple être combinée avec une étape de gravure partielle par plasma des traits de découpe, technique connue sous le terme anglais de « plasma dicing »).

La figure 4B illustre le placement des pavés prélevés du substrat donneur de la figure 4A sur un premier substrat support 1 pour former un substrat pseudo-donneur.

Le placement peut être mis en oeuvre par la technique de « Pick and Place », par laquelle un robot saisit un pavé préalablement découpé dans le substrat donneur et le place à un emplacement prédéterminé sur le premier substrat support.

Dans certains modes de réalisation, chaque pavé adhère au premier substrat support par adhésion moléculaire. A cet effet, des traitements de surface des pavés et/ou du premier substrat support peuvent être mis en oeuvre au préalable afin de favoriser une bonne adhésion moléculaire. Ces traitements peuvent comprendre notamment un nettoyage, le dépôt d'une couche de collage tel qu'un oxyde de silicium (SiO₂), une activation par plasma avant collage et un recuit.

Dans d'autres modes de réalisation, le collage des pavés au premier substrat support peut faire intervenir une couche de collage intermédiaire, par exemple une couche de collage polymère, une couche de collage eutectique ou une couche de colle céramique.

Le premier substrat support 1 présente avantageusement un diamètre supérieur à celui du substrat donneur 2, par exemple un diamètre de l'ordre de 300 mm.

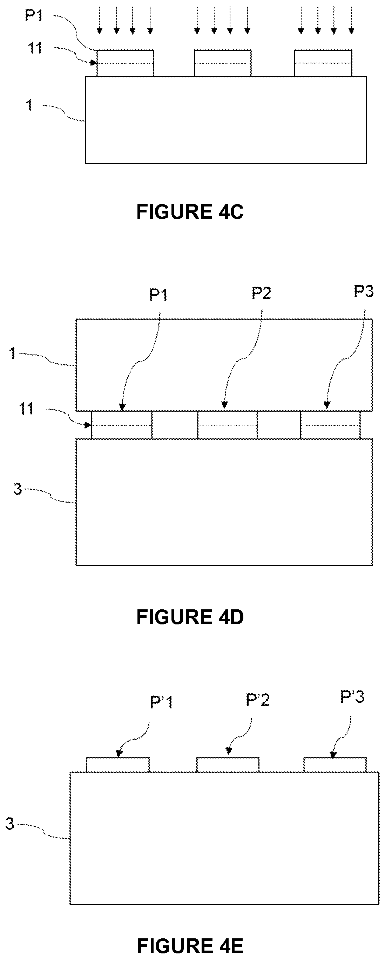

La figure 4C illustre la formation d'une zone de fragilisation dans lesdits pavés P1-P3 afin de délimiter une portion superficielle desdits pavés destinée à être transférée sur un second substrat support. Comme schématisé par les flèches, la zone de fragilisation 11 est avantageusement formée par implantation d'espèces atomiques, telles que de l'hydrogène et/ou de l'hélium, dans les pavés, à une profondeur correspondant à l'épaisseur de la couche à transférer.

La figure 4D illustre le collage du substrat pseudo-donneur de la figure 4C sur un second substrat support par l'intermédiaire des pavés.

De manière particulièrement avantageuse, chaque pavé adhère au second substrat support 3 par adhésion moléculaire. A cet effet, des traitements de surface des pavés et/ou du second substrat support peuvent être mis en oeuvre au préalable afin de favoriser une bonne adhésion moléculaire. Ces traitements peuvent comprendre notamment un nettoyage, le dépôt d'une couche de collage tel qu'un oxyde de silicium (SiO₂), une activation plasma avant collage, un polissage et un recuit, préférentiellement à basse température (c'est-à-dire typiquement en dessous de 300°C).

Le premier substrat support 1 et le second substrat support 3 présentent un diamètre identique, par exemple de l'ordre de 300 mm.

Ensuite, en référence à la figure 4E, les pavés sont détachés le long de la zone de fragilisation 11, afin de transférer les portions P'1, P'2, P'3 délimitées par ladite zone de fragilisation sur le second substrat support.

Les pavés placés sur le premier substrat support présentent typiquement une épaisseur comprise entre 20 µm et 1000 µm, de préférence comprise entre 100 µm et 700 µm. La portion transférée de chaque pavé présente généralement une épaisseur comprise entre 30 nm et 1,5 µm.

Le procédé selon l'invention peut être mis en oeuvre sur le substrat pseudo-donneur de la figure 4B ou 4C et/ou sur la structure finale de la figure 4E.

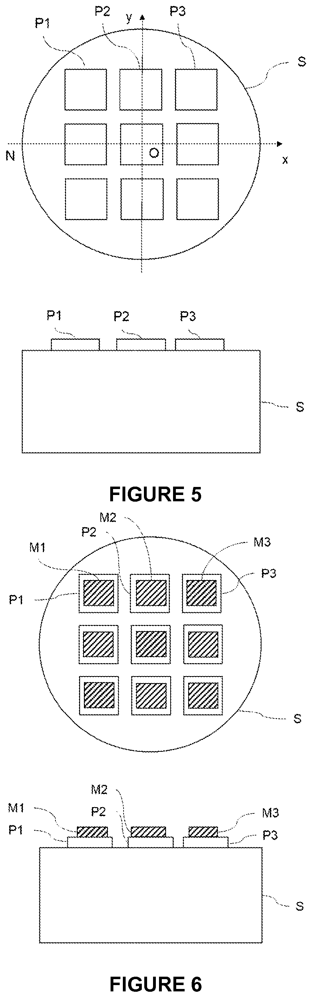

Les étapes du procédé sont illustrées schématiquement sur les figures 5 à 8. Sur ces figures sont représentés des pavés P1-P3 et un substrat support S, mais il va de soi que, selon la structure sur laquelle on applique le procédé, les pavés P1-P3 peuvent être remplacés par les portions de pavés P'1-P'3 tels qu'illustrés sur la figure 4E, et le substrat support S peut être le premier substrat support 1 de la figure 4B ou 4C ou bien le second substrat support 3 de la figure 4E.

La figure 5 illustre un substrat support S sur lequel ont été placés une pluralité de pavés P1-P3. Compte tenu de la technique de découpe et/ou de placement des pavés, lesdits pavés peuvent présenter une géométrie erronée par rapport à une géométrie cible, et/ou une distribution erronée par rapport à une distribution cible. La géométrie cible peut être caractérisée typiquement par une forme des pavés vue de dessus (haut de la figure 5) et/ou des dimensions des pavés. La distribution cible peut être caractérisée par un alignement des pavés les uns par rapport aux autres, une distance entre pavés adjacents, et/ou un emplacement de chaque pavé dans un système de coordonnées du substrat S ou un système de coordonnées de l'ensemble des pavés.

Différents référentiels du substrat et/ou des pavés peuvent être définis par rapport à des marques de repérage (par exemple, sous la forme de croix) réalisées :
- sur le substrat support avant le placement des pavés ou le transfert des pavés, en-dehors des pavés,
- sur les pavés après leur placement ou transfert sur le substrat support, notamment à l'occasion de la gravure d'un pavé choisi (par exemple : le premier pavé placé dans le cas d'un placement par la technique de « Pick and Place », ou un pavé transféré choisi en fonction de son emplacement ou de sa qualité de transfert dans le cas d'un transfert simultané de pavés sur le substrat support).

Un exemple d'un système de coordonnées (O, x, y) du substrat S est schématisé sur la figure 5. Dans cet exemple, le point O est le centre du substrat S. L'axe (Ox) passe par une encoche N (« notch » en anglais) qui préexiste sur le bord du substrat S. L'axe (Oy) est perpendiculaire à l'axe (Ox). Naturellement, d'autres systèmes de coordonnées peuvent être utilisés sans pour autant sortir du cadre de la présente invention.

La figure 6 illustre la formation, par exemple par photolithographie, d'un masque comprenant un film protecteur M1-M3 recouvrant partiellement chaque pavé P1-P3 et des ouvertures s'étendant entre les portions de film protecteur.

Le film protecteur définit un motif correspondant à la géométrie et/ou la distribution cible des pavés.

Le film peut être constitué de toute résine appropriée. En particulier dans le domaine de la microélectronique, de telles résines photosensibles, commercialisées par exemple par les sociétés Shipley ou encore AZ Electronic Materials, sont dispensées à l'état visqueux et étalées sur les substrats à l'aide de tournettes (opération de « spin coating » selon la terminologie anglo-saxonne) puis recuites. Une étape d'insolation UV permet après révélation de garder ou au contraire supprimer les zones exposées. Selon une variante connue sous le nom anglo-saxon de « dry film photo resist », l'application de ces résines peut également se faire par lamination d'un film épais, d'épaisseur typiquement comprise entre 15 et 50 µm, fourni sous forme de rouleaux.

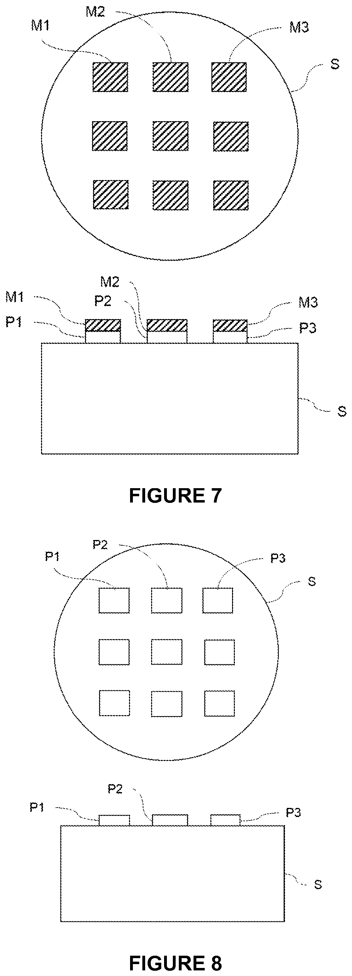

En référence à la figure 7, on applique une solution de gravure sur la structure de la figure 6. La composition de la solution de gravure est choisie en fonction du matériau des pavés. Par exemple, dans le cas où les pavés sont en InP, il pourra être fait appel à une gravure humide dans un bain d'acide chlorhydrique (HCl) et d'acide phosphorique (H₃PO₄). On pourra aussi utiliser une gravure plasma sur la base de gaz halogénés (à base de chlore par exemple ou de mélanges méthane/di-hydrogène (CH₄/H₂).

De manière avantageuse, la solution de gravure n'attaque pas ou peu le matériau du substrat S.

De manière alternative, une gravure par pulvérisation (« sputtering ») sous faisceau d'ions, d'argon par exemple, peut aussi être utilisée. Dans ce cas, le film protecteur est avantageusement métallique.

A l'issue de la gravure, la partie périphérique des pavés non recouverte par le film protecteur a été retirée, sur tout ou partie de l'épaisseur des pavés. Dans certains modes de réalisation, notamment dans le cas où le procédé est mis en œuvre sur le substrat pseudo-donneur avant le transfert des pavés sur un autre substrat, il peut être suffisant de graver les pavés sur une partie seulement de leur épaisseur. Cette partie gravée peut typiquement présenter une épaisseur supérieure ou égale à l'épaisseur à transférer, ou supérieure ou égale à un multiple de l'épaisseur à transférer dans le cas où le substrat pseudo-donneur doit être utilisé à plusieurs reprises pour transférer des pavés. A titre purement indicatif, l'épaisseur de la partie gravée peut ainsi être de l'ordre de quelques dizaines de micromètres. Dans d'autres situations, notamment lorsque le procédé est mis en œuvre après le transfert des pavés, par exemple sur le substrat final, il peut être préférable de graver les pavés sur toute leur épaisseur.

Il subsiste donc, sur le substrat support S, des pavés dont la géométrie et/ou la distribution sont conformes à la géométrie et/ou la distribution cible.

Eventuellement, on peut mettre à profit l'étape de gravure pour former, sur le substrat support et/ou sur un ou plusieurs pavés, une ou plusieurs marques de repérage destinées à faciliter la localisation des différents pavés en vue des étapes technologiques ultérieures. En effet, ce type de marques de repérage est avantageusement utile pour mettre en œuvre certaines étapes technologiques ultérieures, notamment des étapes de lithographie. Par ailleurs, il est fréquent que toutes les étapes ne soient pas réalisées dans une même unité de production et impliquent un conditionnement et un transport de structures ayant subi certaines étapes de fabrication vers un autre site pour la mise en œuvre des étapes de fabrication suivantes en se repérant avec lesdites marques de repérage.

En référence à la figure 8, on retire le film protecteur de sorte à libérer la surface des pavés. La structure est donc prête pour les étapes de fabrication ultérieures, par exemple un dépôt ou une épitaxie d'une ou plusieurs couches additionnelles sur les pavés, la formation de composants électroniques dans ou sur les pavés, etc. Dans le cas où le substrat support S n'est pas le support final, les pavés peuvent être transférés sur un nouveau substrat support, avant ou après la mise en oeuvre des étapes de fabrication susmentionnées.

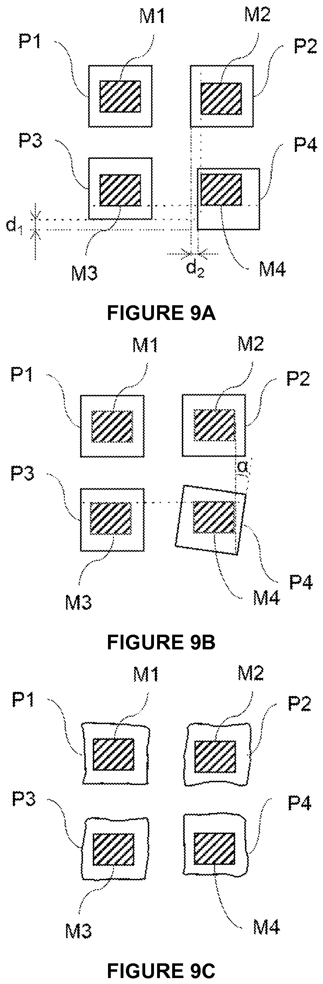

Les figures 9A à 9C illustrent des exemples de correction de la géométrie et/ou de la distribution des pavés.

Dans le cas de la figure 9A, qui correspond au défaut illustré sur la figure 2A, le défaut d'alignement du pavé P4 par rapport aux pavés P2 et P3 est corrigé par l'utilisation d'un masque dont les portions M2 et M4 sont alignées horizontalement et dont les portions M3 et M4 sont alignées verticalement. Par conséquent, à l'issue de la gravure, les pavés subsistant sous les portions M2, M3 et M4 du film protecteur sont parfaitement alignés.

Dans le cas de la figure 9B, qui correspond au défaut illustré sur la figure 2B, le défaut d'orientation du pavé P4 par rapport aux pavés P2 et P3 est corrigé par l'utilisation d'un masque dont les portions M2 et M4 sont alignées horizontalement et dont les portions M3 et M4 sont alignées verticalement, la portion de film protecteur M4 étant inscrite dans la géométrie du pavé P4. Par conséquent, à l'issue de la gravure, les pavés subsistant sous les portions M2, M3 et M4 du film protecteur sont parfaitement parallèles et alignés.

Dans le cas de la figure 9C, qui correspond au défaut illustré sur la figure 2C, les irrégularités de bord des pavés P1-P4 dus au transfert de couche sont corrigés par l'utilisation d'un masque dont les portions M1-M4 présentent une géométrie conforme à la géométrie souhaitée, chaque portion de film protecteur M1-M4 étant inscrite dans la géométrie du pavé P1-P4 respectif.

Comme indiqué plus haut, le procédé selon l'invention peut également être utilisé pour subdiviser un pavé en plusieurs pavés plus petits. Dans ce cas, le défaut de géométrie et/ou de distribution peut être considéré comme erroné simplement en ce que le nombre de pavés placés sur le substrat support ne correspond pas au nombre de pavés attendu, même si les pavés sont parfaitement alignés.

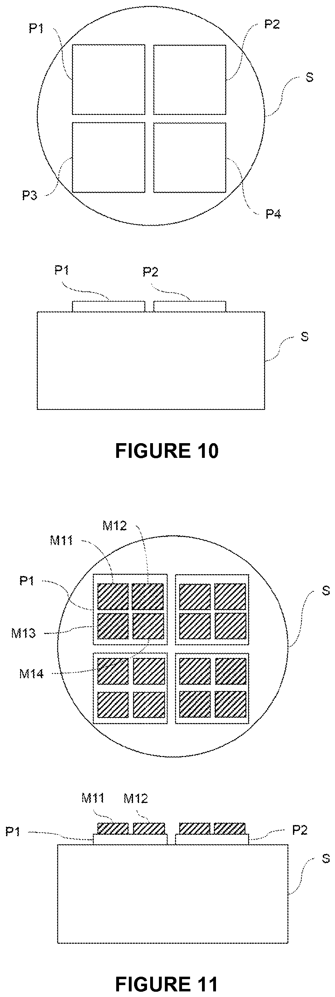

Les figures 10 à 13 illustrent une telle forme d'exécution du procédé.

Comme illustré sur la figure 10, quatre pavés P1-P4 ont été placés sur un substrat support S. Le placement de ces pavés peut avoir été réalisé directement à partir d'un substrat donneur, par exemple au moyen de la technique « Pick and Place », ou à partir d'un substrat pseudo-donneur selon le procédé illustré sur les figures 4A-4E.

Lesdits pavés présentent de relativement grandes dimensions, supérieures à la dimension nécessaire à la réalisation des composants visés. Plus précisément, chaque pavé présente une dimension supérieure à un multiple de la dimension des pavés ciblée dans le procédé de fabrication. Par exemple, chaque pavé peut présenter une dimension deux ou quatre fois supérieure à la dimension ciblée.

En référence à la figure 11, on forme, par exemple par photolithographie, un masque sur lesdits pavés de manière à définir le motif souhaité pour les pavés finaux.

Le masque comprend plusieurs portions de film protecteur sur chaque pavé. Ainsi, le pavé P1 est recouvert de quatre portions M11, M12, M13, M14 de film protecteur, séparées par une ouverture en forme de croix.

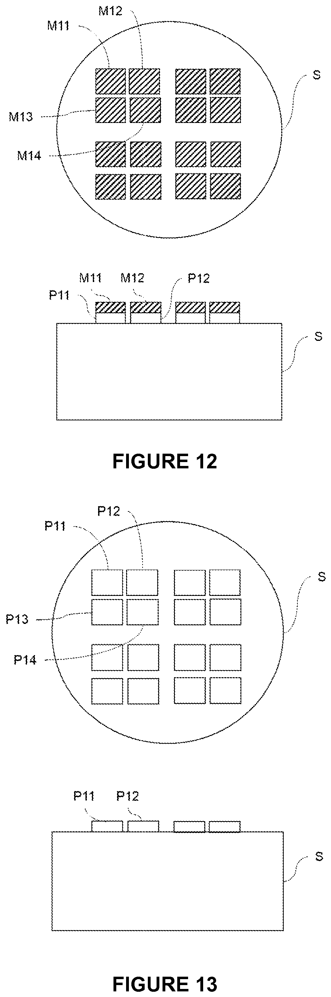

En référence à la figure 12, on applique la solution de gravure sur la structure de la figure 11. Par conséquent, non seulement la périphérie des pavés est gravée, mais aussi la partie centrale non recouverte par le film protecteur.

En référence à la figure 13, on retire le film protecteur de sorte à libérer la surface des pavés.

A l'issue de la gravure, chaque pavé (par exemple le pavé P1) a donc été subdivisé en quatre pavés (respectivement P11, P12, P13, P14).

Dans l'exemple illustré, la distance entre le pavé P1 et les pavés adjacents est supérieure à la distance entre les pavés P11-P14 formés à partir du pavé P1. Cependant, il est bien sûr possible d'agencer les pavés initiaux et finaux de sorte à former une matrice de pavés présentant une géométrie parfaitement régulière avec une distance identique entre tous les pavés obtenus. Inversement, il est possible, grâce au masque et à la gravure localisée, de former une matrice de pavés présentant une géométrie complexe.

Par rapport à un procédé dans lequel chaque pavé P11-P14 aurait été placé individuellement sur le substrat support S, par exemple par la technique « Pick and Place », la formation des pavés P11-P14 selon l'invention est plus rapide car elle n'implique qu'une seule étape de placement du pavé P1.

Le procédé selon l'invention peut être mis en oeuvre directement sur les pavés placés sur le premier substrat support, ou transférés sur le second substrat support. Cependant, de manière particulièrement avantageuse, lorsqu'une ou plusieurs couches additionnelles sont formées sur lesdits pavés, le procédé selon l'invention peut être mis en oeuvre après la formation de la ou lesdites couches additionnelles.

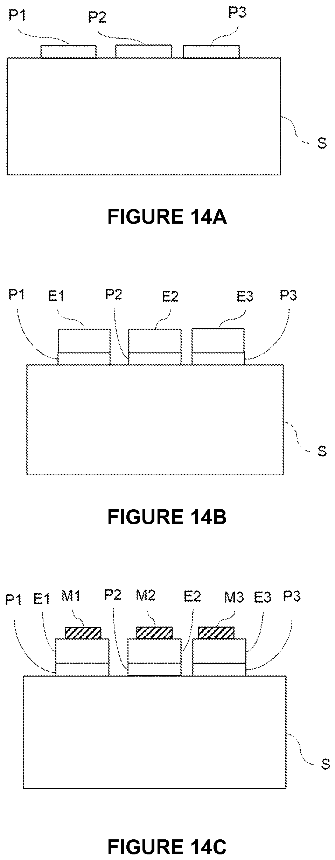

Les figures 14A à 14D illustrent une forme d'exécution du procédé dans laquelle une couche épitaxiale E1, E2, E3 (cf. figure 14B) a été formée sur chaque pavé P1, P2, P3 placé sur le substrat support S (cf. figure 14A). Par exemple, les pavés sont en un matériau monocristallin présentant un paramètre de maille et une qualité cristalline adaptés pour la croissance épitaxiale des couches E1-E3. Les couches E1-E3 peuvent être constituées du même matériau que les pavés, la croissance épitaxiale permettant d'épaissir les pavés. De manière alternative, les couches épitaxiales E1-E3 peuvent être constituées d'un matériau différent de celui des pavés, la croissance épitaxiale permettant de former un empilement composite.

Comme illustré sur la figure 14C, le film protecteur M1, M2, M3 formant le masque est déposé sur la surface de chaque couche épitaxiale E1, E2, E3.

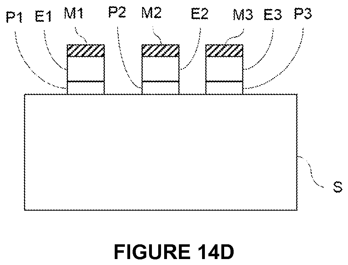

En référence à la figure 14D, une solution de gravure adaptée pour attaquer le matériau des pavés et le matériau des couches épitaxiales est appliquée. A l'issue de la gravure, seul le matériau des pavés et des couches épitaxiales protégé par le film protecteur subsiste.

Le film protecteur peut ensuite être retiré pour libérer la surface des couches épitaxiales et permettre la poursuite du procédé de fabrication de composants électroniques dans ou sur les pavés et couches épitaxiales.

Ainsi, l'invention permet de différer l'ajustement de la géométrie et de l'alignement des pavés au stade le plus opportun du procédé de fabrication.

### Exemples d'applications

La présente invention présente différents cas d'applications particulièrement avantageux, notamment dans le domaine de la microélectronique.

Selon une première forme d'exécution, le procédé peut permettre de corriger la géométrie et la distribution d'une pluralité de pavés de relativement grandes dimensions (c'est-à-dire présentant des côtés de quelques millimètres de long) et espacés de quelques millimètres, placés sur un substrat support de 300 mm de diamètre. Ledit substrat support peut être un substrat de silicium ou un substrat de type silicium sur isolant (SOI, acronyme du terme anglo-saxon « Silicon On Insulator »).

Dans des applications photoniques, la couche active du SOI peut comprendre un circuit photonique comportant des dispositifs passifs ou actifs, par exemple un ou plusieurs guide(s) d'onde, un ou plusieurs multiplexeur(s), un ou plusieurs micro-résonateurs, etc. Les pavés transférés sur cette couche peuvent être en InP, qui est un matériau plus adapté que le silicium pour la croissance épitaxiale d'un empilement de matériaux III-V permettant de former un laser.

Compte tenu de la relativement grande taille des pavés d'InP, plusieurs circuits peuvent éventuellement être réalisés au sein de chaque pavé.

Selon une forme d'exécution alternative, les pavés susmentionnés sont subdivisés en pavés de plus petites dimensions par le procédé selon l'invention, chaque pavé initial définissant une cellule comprenant une pluralité de puces formées chacune dans un pavé de petites dimensions. On peut ainsi former sur le substrat support deux niveaux d'agencement de pavés : un premier niveau à l'échelle des cellules, qui sont agencées sur le substrat support selon un premier motif, et un second niveau à l'échelle des puces, qui sont agencées au sein de la cellule respective selon un second motif.

Dans des applications radiofréquences (RF), la couche active du SOI peut comprendre des composants fonctionnant à relativement basse fréquence, tandis que les pavés, qui sont avantageusement réalisés en InP ou en GaN, peuvent comprendre les composants fonctionnant aux plus hautes fréquences. Pour de telles applications, la taille des pavés, après correction de leur alignement et/ou géométrie, peut aller jusqu'à 1 cm de longueur de côté. Les pavés sont avantageusement disposés densément sur le substrat support, par exemple avec une distance entre pavés, après correction de leur alignement et/ou géométrie, typiquement inférieure à 300 µm.

Dans des applications micro-LEDs, la taille des pavés de GaN, après correction de leur alignement et/ou géométrie, est avantageusement inférieure à 50 µm.

## Revendications

1. Procédé de fabrication d'une structure comprenant au moins deux pavés sur un substrat, comprenant :
- le placement, sur un substrat support (1, 3, S), d'au moins deux pavés ((P1, P2), (P'1, P'2)) lesdits pavés étant agencés sur ledit substrat (1, 3, S) support selon une distribution et/ou une géométrie erronée par rapport à une distribution et/ou une géométrie cible ;
- la formation d'un masque comprenant un film protecteur (M1, M2) recouvrant en partie lesdits pavés ((P1, P2), (P'1, P'2)) selon un motif définissant la distribution et/ou la géométrie cible et au moins une ouverture s'étendant autour du film protecteur (M1, M2) ;
- la gravure d'au moins un pavé (P1, P2, P'1, P'2) au travers de l'ouverture du masque de sorte à corriger l'agencement des pavés selon la distribution et/ou la géométrie cible.

2. Procédé selon la revendication 1, dans lequel le motif est défini dans un système de coordonnées de l'ensemble des pavés.

3. Procédé selon la revendication 1, dans lequel le motif est défini dans un système de coordonnées du substrat support.

4. Procédé selon l'une des revendications 1 à 3, dans lequel les pavés (P1, P2) sont placés successivement sur le substrat support.

5. Procédé selon l'une des revendications 1 à 3, dans lequel les pavés (P'1, P'2) sont placés simultanément sur le substrat support.

6. Procédé selon la revendication 5, comprenant :
- la formation d'un substrat pseudo-donneur par placement de chaque pavé d'au moins un substrat donneur (2) sur un premier substrat support (1) ;
- le collage dudit substrat pseudo-donneur sur un second substrat support (3) par l'intermédiaire des pavés (P1, P2) ;
- le transfert d'une portion (P'1, P'2) desdits pavés sur le second substrat support (2).

7. Procédé selon la revendication 6, dans lequel le premier et le second substrat support présentent un diamètre identique, supérieur au diamètre du substrat donneur.

8. Procédé selon l'une des revendications 6 à 7, dans lequel le collage du substrat pseudo-donneur sur le second substrat support (3) est réalisé par adhésion moléculaire.

9. Procédé selon l'une des revendications 6 à 8, dans lequel le transfert de chaque portion de pavé comprend successivement la formation d'une zone de fragilisation (11) par implantation d'espèces atomiques dans chaque pavé placé sur le substrat pseudo-donneur pour définir une portion à transférer, le collage du substrat pseudo-donneur sur le second substrat support par l'intermédiaire des pavés, et le détachement de chaque pavé le long de la zone de fragilisation.

10. Procédé selon la revendication 9, dans lequel chaque pavé présente une épaisseur comprise entre 20 µm et 1000 µm, de préférence comprise entre 100 µm et 700 µm, et la portion transférée de chaque pavé présente une épaisseur comprise entre 30 nm et 1,5 µm.

11. Procédé selon l'une des revendications 6 à 10, dans lequel la formation du masque et la gravure sont mises en oeuvre après le transfert de chaque portion de pavé sur le second substrat support.

12. Procédé selon l'une des revendications 6 à 11, dans lequel la formation du masque et la gravure sont mises en oeuvre sur les pavés du substrat pseudo-donneur avant le collage sur le second substrat support.

13. Procédé selon l'une des revendications 6 à 12, dans lequel, pour former le substrat pseudo-donneur, chaque pavé est placé dans une cavité du premier substrat support.

14. Procédé selon l'une des revendications 1 à 13, dans lequel chaque pavé présente un côté de longueur inférieure ou égale à 10 mm, de préférence inférieure ou égale à 5 mm, et de manière encore préférée inférieure ou égale à 2 mm.

15. Procédé selon l'une des revendications 1 à 13, dans lequel chaque pavé présente un côté de longueur supérieure ou égale à 3 mm, de préférence supérieure ou égale à 5 mm, et de manière préférée supérieure ou égale à 8 mm.

16. Procédé selon la revendication 14, dans lequel le film protecteur recouvre chaque pavé selon au moins deux motifs séparés par des ouvertures et la gravure dudit pavé au travers desdites ouvertures du masque forme au moins deux portions de pavés selon les motifs à partir dudit pavé.

17. Procédé selon l'une des revendications 1 à 16, dans lequel chaque pavé comprend :
- un matériau semi-conducteur, tel qu'un matériau III-V, notamment le nitrure d'indium (InN), le nitrure de gallium (GaN), le nitrure d'aluminium (AIN), l'arséniure d'indium (InAs), l'arséniure de gallium (GaAs), l'arséniure d'aluminium (AlAs), le phosphure d'indium (InP), le phosphure de gallium (GaP) ou le phosphure d'aluminium (AIP), ou un matériau IV ou IV-IV, notamment le germanium ou le carbure de silicium (SiC),
- un matériau piézoélectrique, tel que le tantalate de lithium (LiTaO₃), le niobate de lithium (LiNbO₃), le niobate de potassium-sodium (KₓNa₁₋ₓNbO₃ ou KNN), le titanate de baryum (BaTiO₃), le quartz, le titano-zirconate de plomb (PZT), un composé de niobate de plomb-magnésium et de titanate de plomb (PMN-PT), l'oxide de zinc (ZnO), le nitrure d'aluminium (AIN) ou le nitrure d'aluminium et de scandium (AIScN), et/ou
- un matériau électriquement isolant, tel que le diamant, le titanate de strontium, la zircone yttriée ou le saphir.

18. Procédé selon l'une des revendications 1 à 17, comprenant la formation d'au moins une couche épitaxiale (E1, E2, E3) sur chaque pavé (P1, P2, P3), la formation du masque et la gravure étant mises en oeuvre après ladite étape d'épitaxie.

## Patentansprüche

1. Verfahren zur Herstellung einer Struktur, die mindestens zwei Plättchen auf einem Substrat umfasst, umfassend:
- das Platzieren von mindestens zwei Plättchen ((P1, P2), (P'1, P'2)) auf einem Trägersubstrat (1, 3, S), wobei die Plättchen auf dem Trägersubstrat (1, 3, S) in einer fehlerhaften Verteilung und/oder Geometrie in Bezug auf eine Zielverteilung und/oder -geometrie angeordnet sind;
- das Bilden einer Maske, die einen Schutzfilm (M1, M2) umfasst, der die Plättchen ((P1, P2), (P'1, P'2)) zum Teil gemäß einem Muster bedeckt, das die Zielverteilung und/oder -geometrie definiert, und mindestens eine Öffnung, die sich um den Schutzfilm (M1, M2) herum erstreckt;
- das Ätzen mindestens eines Plättchens (P1, P2, P'1, P'2) durch die Öffnung der Maske derart, dass die Anordnung der Plättchen gemäß der Zielverteilung und/oder -geometrie korrigiert wird.

2. Verfahren nach Anspruch 1, wobei das Muster in einem Koordinatensystem der Gesamtheit der Plättchen definiert ist.

3. Verfahren nach Anspruch 1, wobei das Muster in einem Koordinatensystem des Trägersubstrats definiert ist.

4. Verfahren nach einem der Ansprüche 1 bis 3, wobei die Plättchen (P1, P2) nacheinander auf dem Trägersubstrat platziert werden.

5. Verfahren nach einem der Ansprüche 1 bis 3, wobei die Plättchen (P'1, P'2) gleichzeitig auf dem Trägersubstrat platziert werden.

6. Verfahren nach Anspruch 5, umfassend:
- das Bilden eines Pseudodonorsubstrats durch Platzieren jedes Plättchens mindestens eines Donorsubstrats (2) auf einem ersten Trägersubstrat (1);
- das Kleben des Pseudodonorsubstrats auf ein zweites Trägersubstrat (3) mittels der Plättchen (P1, P2);
- das Übertragen eines Abschnitts (P'1, P'2) der Plättchen auf das zweite Trägersubstrat (2).

7. Verfahren nach Anspruch 6, wobei das erste und das zweite Trägersubstrat einen identischen Durchmesser aufweisen, der größer ist als der Durchmesser des Donorsubstrats.

8. Verfahren nach einem der Ansprüche 6 bis 7, wobei das Kleben des Pseudodonorsubstrats auf das zweite Trägersubstrat (3) durch molekulare Adhäsion durchgeführt wird.

9. Verfahren nach einem der Ansprüche 6 bis 8, wobei die Übertragung jedes Plättchenabschnitts nacheinander das Bilden einer Schwächungszone (11) durch Implantation atomarer Spezies in jedes auf dem Pseudodonorsubstrat platziertes Plättchen, um einen zu übertragenden Abschnitt zu definieren, das Kleben des Pseudodonorsubstrats auf das zweite Trägersubstrat mittels der Plättchen und das Ablösen jedes Plättchens entlang der Schwächungszone umfasst.

10. Verfahren nach Anspruch 9, wobei jedes Plättchen eine Dicke zwischen 20 µm und 1000 µm, vorzugsweise zwischen 100 µm und 700 µm aufweist und der übertragene Abschnitt jedes Plättchens eine Dicke zwischen 30 nm und 1,5 µm aufweist.

11. Verfahren nach einem der Ansprüche 6 bis 10, wobei das Bilden der Maske und das Ätzen nach dem Übertragen jedes Plättchenabschnitts auf das zweite Trägersubstrat durchgeführt werden.

12. Verfahren nach einem der Ansprüche 6 bis 11, wobei das Bilden der Maske und das Ätzen auf den Plättchen des Pseudodonorsubstrats vor dem Kleben auf das zweite Trägersubstrat durchgeführt werden.

13. Verfahren nach einem der Ansprüche 6 bis 12, wobei zur Bildung des Pseudodonorsubstrats jedes Plättchen in eine Vertiefung des ersten Trägersubstrats platziert wird.

14. Verfahren nach einem der Ansprüche 1 bis 13, wobei jedes Plättchen eine Seite mit einer Länge von weniger als oder gleich 10 mm, vorzugsweise von weniger als oder gleich 5 mm und noch bevorzugter von weniger als oder gleich 2 mm aufweist.

15. Verfahren nach einem der Ansprüche 1 bis 13, wobei jedes Plättchen eine Seite mit einer Länge von über oder gleich 3 mm, vorzugsweise von über oder gleich 5 mm und noch bevorzugter von über oder gleich 8 mm aufweist.

16. Verfahren nach Anspruch 14, wobei die Schutzfolie jedes Plättchen gemäß mindestens zwei durch Öffnungen getrennten Mustern bedeckt und das Ätzen des Plättchens durch die Öffnungen der Maske mindestens zwei Plättchenabschnitte gemäß den Mustern ausgehend von dem Plättchen bildet.

17. Verfahren nach einem der Ansprüche 1 bis 16, wobei jedes Plättchen umfasst:
- ein Halbleitermaterial, wie beispielsweise ein III-V-Material, insbesondere Indiumnitrid (InN), Galliumnitrid (GaN), Aluminiumnitrid (AlN), Indiumarsenid (InAs), Galliumarsenid (GaAs), Aluminiumarsenid (AlAs), Indiumphosphid (InP), Galliumphosphid (GaP) oder Aluminiumphosphid (AlP), oder ein IV- oder IV-IV-Material, insbesondere Germanium oder Siliziumkarbid (SiC),
- ein piezoelektrisches Material, wie beispielsweise Lithiumtantalat (LiTaO₃), Lithiumniobat (LiNbO₃), Kalium-Natrium-Niobat (KₓNa₁₋ₓNbO₃ oder KNN), Bariumtitanat (BaTiO₃), Quarz, Blei-Zirkonat-Titanat (PZT), eine Verbindung aus Bleimagnesiumniobat und Bleititanat (PMN-PT), Zinkoxid (ZnO), Aluminiumnitrid (AlN) oder Aluminium-Scandium-Nitrid (AlScN), und/oder
- ein elektrisch isolierendes Material, wie beispielsweise Diamant, Strontiumtitanat, Yttriumzirkonat oder Saphir.

18. Verfahren nach einem der Ansprüche 1 bis 17, umfassend die Bildung mindestens einer Epitaxieschicht (E1, E2, E3) auf jedem Plättchen (P1, P2, P3), wobei die Bildung der Maske und das Ätzen nach dem Epitaxieschritt durchgeführt werden.

## Claims

1. Method for manufacturing a structure comprising at least two tiles on a substrate, comprising:
- placing, on a support substrate (1, 3, S), at least two tiles ((P1, P2), (P'1, P'2)), said tiles being arranged on said support substrate (1, 3, S) in a distribution and/or geometry that is incorrect with respect to a target distribution and/or geometry;
- forming a mask comprising a protective film (M1, M2) partially covering said tiles ((P1, P2), (P'1, P'2)) according to a pattern defining the target distribution and/or geometry and at least one opening extending around the protective film (M1, M2);
- etching at least one tile (P1, P2, P'1, P'2) through the opening in the mask so as to correct the arrangement of the tiles according to the target distribution and/or geometry.

2. Method according to claim 1, wherein the pattern is defined in a coordinate system of the set of tiles.

3. Method according to claim 1, wherein the pattern is defined in a coordinate system of the support substrate.

4. Method according to one of claims 1 to 3, wherein the tiles (P1, P2) are placed successively on the support substrate.

5. Method according to one of claims 1 to 3, wherein the tiles (P'1, P'2) are placed simultaneously on the support substrate.

6. Method according to claim 5, comprising:
- forming a pseudo-donor substrate by placing each tile of at least one donor substrate (2) on a first support substrate (1);
- bonding said pseudo-donor substrate to a second support substrate (3) via the tiles (P1, P2);
- transferring a portion (P'1, P'2) of said tiles onto the second support substrate (2).

7. Method according to claim 6, wherein the first and second support substrates have an identical diameter, greater than the diameter of the donor substrate.

8. Method according to one of claims 6 to 7, wherein the pseudo-donor substrate is bonded to the second support substrate (3) by molecular adhesion.

9. Method according to one of claims 6 to 8, wherein the transfer of each tile portion comprises, in succession: the formation of a weakening zone (11) by implanting atomic species into each tile placed on the pseudo-donor substrate to define a portion to be transferred, bonding the pseudo-donor substrate to the second support substrate via the tiles, and detaching each tile along the weakening zone.

10. Method according to claim 9, wherein each tile has a thickness between 20 µm and 1000 µm, preferably between 100 µm and 700 µm, and the transferred portion of each tile has a thickness between 30 nm and 1.5 µm.

11. Method according to one of claims 6 to 10, wherein the formation of the mask and the etching are carried out after the transfer of each tile portion onto the second support substrate.

12. Method according to one of claims 6 to 11, wherein the formation of the mask and the etching are carried out on the tiles of the pseudo-donor substrate before bonding to the second support substrate.

13. Method according to one of claims 6 to 12, wherein, to form the pseudo-donor substrate, each tile is placed in a cavity in the first support substrate.

14. Method according to one of claims 1 to 13, wherein each tile has a side length less than or equal to 10 mm, preferably less than or equal to 5 mm, and more preferably less than or equal to 2 mm.

15. Method according to one of claims 1 to 13, in which each tile has a side length greater than or equal to 3 mm, preferably greater than or equal to 5 mm, and preferably greater than or equal to 8 mm.

16. Method according to claim 14, wherein the protective film covers each tile according to at least two patterns separated by openings, and the etching of said tile through said openings in the mask forms at least two portions of tiles according to the patterns from said tile.

17. Method according to one of claims 1 to 16, wherein each tile comprises:
- a semiconductor material, such as a III-V material, in particular indium nitride (InN), gallium nitride (GaN), aluminum nitride (AIN), indium arsenide (InAs), gallium arsenide (GaAs), aluminum arsenide (AlAs), indium phosphide (InP), gallium phosphide (GaP), or aluminum phosphide (AlP), or a IV or IV-IV material, such as germanium or silicon carbide (SiC),
- a piezoelectric material, such as lithium tantalate (_{LiTaO₃}), lithium niobate (_{LiNbO₃}), potassium-sodium niobate (KₓNa₁₋ₓNbO₃ NbO₃ or KNN), barium titanate (BaTiO₃ ), quartz, lead zirconate titanate (PZT), a lead magnesium niobate-lead titanate compound (PMN-PT), zinc oxide (ZnO), aluminum nitride (AIN) or aluminum scandium nitride (AIScN), and/or
- an electrically insulating material, such as diamond, strontium titanate, yttria-stabilized zirconia, or sapphire.

18. Method according to one of claims 1 to 17, comprising the formation of at least one epitaxial layer (E1, E2, E3) on each tile (P1, P2, P3), the formation of the mask and the etching being carried out after said epitaxy step.
